Europäisches Patentamt

European Patent Office

Office européen des brevets

(19)

(11) Publication number: **0 131 633**
**B1**

# (12) EUROPEAN PATENT SPECIFICATION

(45) Date of publication of patent specification: **26.10.88**

(51) Int. Cl.⁴: **H 03 D 9/06**

(21) Application number: **84900532.7**

(22) Date of filing: **13.01.84**

(86) International application number:
**PCT/JP84/00004**

(87) International publication number:
**WO 84/03008 02.08.84 Gazette 84/18**

## (54) FREQUENCY CONVERTER.

(30) Priority: **20.01.83 JP 8429/83**
**18.02.83 JP 26532/83**

(43) Date of publication of application:
**23.01.85 Bulletin 85/04**

(45) Publication of the grant of the patent:
**26.10.88 Bulletin 88/43**

(84) Designated Contracting States:
**DE FR GB**

(56) References cited:
**EP-A-0 015 838**
**JP-A-54 071 916**
**JP-B-51 041 283**
**JP-B-51 041 306**
**JP-B-52 025 054**
**US-A-2 816 271**
**US-A-3 349 346**
**9TH EUROPEAN MICROWAVE CONFERENCE,**
**17th-20th September 1979, pages 726-730,**
**Brighton, Sevenoaks, Kent, GB; B. VOWINKEL:**
**"Image recovery millimeter-wave mixer",**
**Idem**

(73) Proprietor: **Matsushita Electric Industrial Co., Ltd.**
**1006, Oaza Kadoma**
**Kadoma-shi Osaka-fu, 571 (JP)**

(72) Inventor: **SHIOMI, Yasufumi**
**1-43, Shimizu Suita-shi**
**Osaka-fu 565 (JP)**
Inventor: **YOSHIMURA, Yoshikazu**
**1-18-3-212, Matsugaoka**
**Takatsuki-shi Osaka-fu 569 (JP)**

(74) Representative: **Crawford, Andrew Birkby et al**
**A.A. THORNTON & CO. Northumberland House**
**303-306 High Holborn**
**London WC1V 7LE (GB)**

(56) References cited:
**PATENTS ABSTRACTS OF JAPAN, vol. 1, no.**
**72, 13th July 1977, page 750E77; & JP - A - 52**
**9348 (MATSUSHITA DENKI SANGYO K.K.)**
**24-01-1977**
**PATENTS ABSTRACTS OF JAPAN, vol. 1, no.**
**72, 13th July 1977, page 750E77; & JP - A - 52**
**9347 (MATSUSHITA DENKI SANGYO K.K.)**
**24-01-1977**

## Description

### Field of the invention

The present invention relates to a frequency converter intended to convert the frequency of an input signal of microwave into a lower frequency for use in a converter or the like for satellite broadcast reception.

### Background of the invention

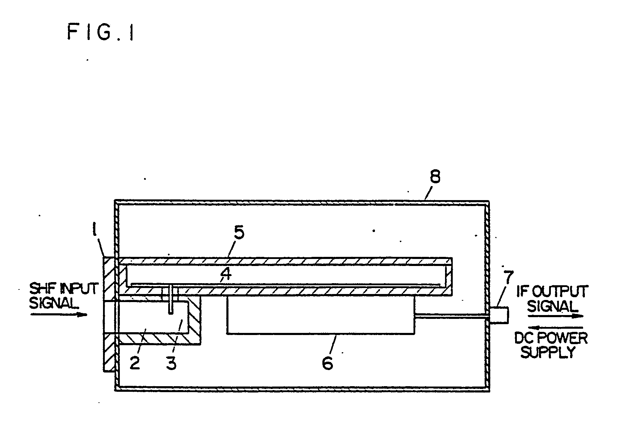

Generally, a frequency converter for satellite communication wherein reception signals of SHF band are fed through waveguide is composed as shown in Fig. 1. That is, it consists of input flange unit 1 in which the SHF signal from the broadcast satellite is first applied, rectangular waveguide unit 2 which is provided in the final end of rectangular waveguide and possesses a rectangular waveguide-microstrip line converter unit 3, microwave integrated circuit (MIC) 4 which is housed in a shield case 5 and responsible for processing of reception signals, and other attached circuits 6. Besides, numeral 7 is an output terminal, and numeral 8 is an outer case which comprises the rectangular waveguide unit 2 having said rectangular waveguide-microstrip converter unit 3, microwave integrated circuit 4, shield case 5 and attached circuits 6.

In this constitution, the SHF signal from the satellite supplied from the input flange unit 1 propagates through the rectangular waveguide unit 2 and enters the microwave integrated circuit 4 by way of rectangular waveguide-microstrip line converter unit 3. In this microwave integrated circuit 4, the signal is amplified and frequency-converted, and is delivered from the output terminal 7 as a signal of intermediate frequency.

As well known, the frequency converter for satellite communication is required to have a large image suppresion ratio, small leakage of local oscillation frequency, and low noise index. In this respect, in the conventional constitution as shown in Fig. 1, the image suppression ratio and leakage of local oscillation signal were forced to depend only on the microwave integrated circuit 4, and there was a limit to the circuit design and satisfactory performance could not be obtained.

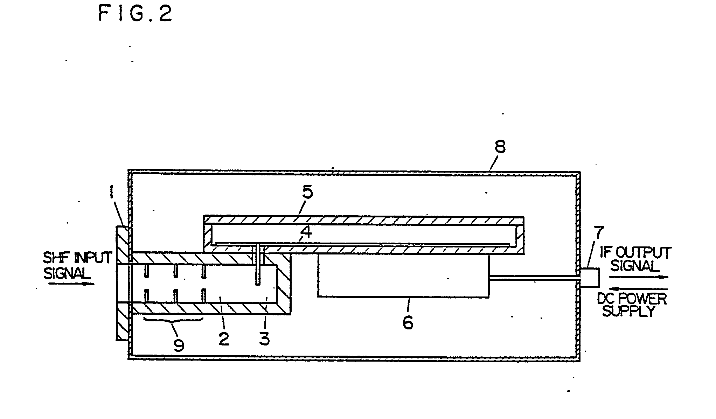

Another example of a conventional frequency converter is shown in Fig. 2, wherein same numbers are attached to the same parts as in Fig. 1. The converter in Fig. 2 is furnished with a waveguide type filter 9 in the rectangular waveguide unit 2 in order to satisfy the requirements of image suppression ratio and local oscillation signal leakage which were the defects in the conventional example shown in Fig. 1. The other constitution is similar to that of Fig. 1.

In this constitution, the performances of the image suppression ratio and local oscillation frequency may be sufficiently satisfied, but the insertion loss of said filter 9 exerts adverse effects on the noise index as frequency converter, which is a serious defect.

The proceedings of the 9th European Microwave Conference, held on 17th—20th September 1979 in Brighton, England, include, on pages 726—730, an article entitled "Image Recovery millimeter—wave mixer" by B. Vowinkel. This article discloses a frequency converter comprising a circular wave guide unit having an end to which a reception signal is applied, a rectangular waveguide unit and a circular-rectangular waveguide converter unit which connects the other end of the circular waveguide unit to the rectangular waveguide unit to convert a transmission mode of the reception signal from $TE_{11}$ mode in the circular waveguide into a $TE_{10}$ mode in the rectangular waveguide which is a main mode thereof; wherein the diameter of the circular waveguide unit is selected so that the cutoff frequency of the circular waveguide unit is lower than the frequency of the signal to be processed and higher than the local oscillation frequency so as to cause the circular waveguide unit to function as a high pass filter. In this arrangement, the axes of the circular waveguide and the rectangular waveguide are aligned. Although this arrangement has been found to achieve significant improvements over prior frequency converters, the noise index characteristics are unsatisfactory.

US—A—3349346 discloses a rectangular to circular waveguide transition in which the cross section of the waveguide gradually changes shape from rectangular to circular such that the axis of the rectangular portion is displaced with respect to the axis of the circular portion parallel to the direction of a longer side of the rectangular portion. Displacement of the axis of the waveguides in this way does not significantly improve the noise index characteristics.

The present invention is intended to present a frequency converter which may satisfy not only the image suppression ratio and leakage prevention of local oscillation signal, but also the noise index characteristic.

More particularly, the object of the present invention is to present a frequency converter which is reduced in size while satisfying all of said image suppression ratio, local oscillation signal leakage prevention and noise index characteristics.

The present invention provides a circular waveguide unit having an end to which a reception signal is applied, a rectangular waveguide unit and a circular-rectangular waveguide converter unit which connects to the other end of the circular waveguide unit to the rectangular waveguide unit to convert a transmission mode of the reception signal from $TE_{11}$ mode in the circular waveguide into a $TE_{10}$ mode in the rectangular waveguide which is a main mode thereof; wherein the diameter of the circular waveguide unit is selected so that the cutoff frequency of the circular waveguide unit is lower than the frequency of the signal to be processed and higher than the local oscillation frequency so as to cause the circular waveguide unit to function as a high pass filter, characterised in that a rectangular waveguide-microstrip line converter unit is provided at the final end of the rectangular waveguide and a microwave integrated circuit is provided to process the reception signal fed there to through the rectangular waveguide-microstrip line converter unit to produce the processed signal as a signal of intermediate frequency, and the axis of said rectangular waveguide is arranged to be displaced with respect to the circular waveguide unit parallel to the direction of a shorter side of the rectangular waveguide unit and said microwave integrated circuit is provided at the side of the walls of said circular-rectangular waveguide converter unit and said rectangular waveguide unit towards which the axis of the rectangular waveguide unit is displaced.

Brief description of the drawings

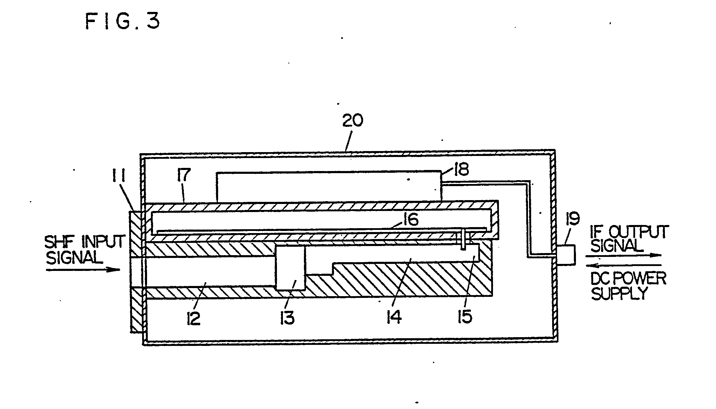

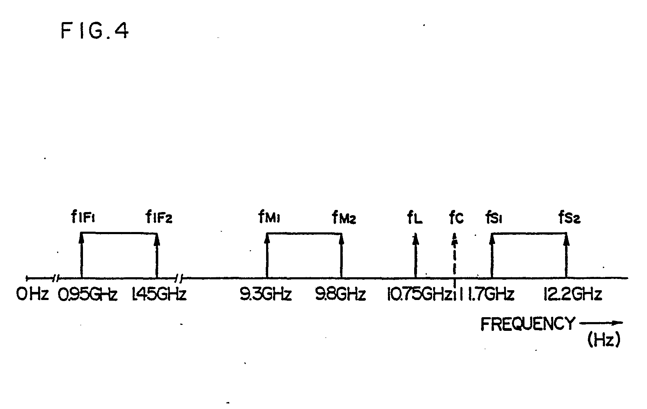

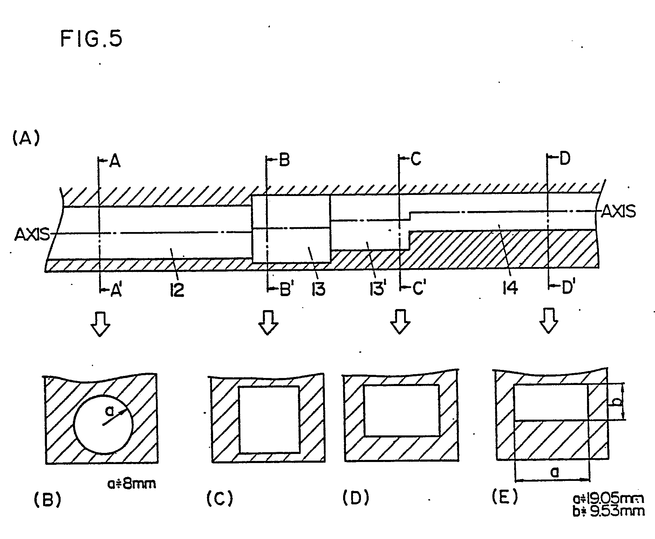

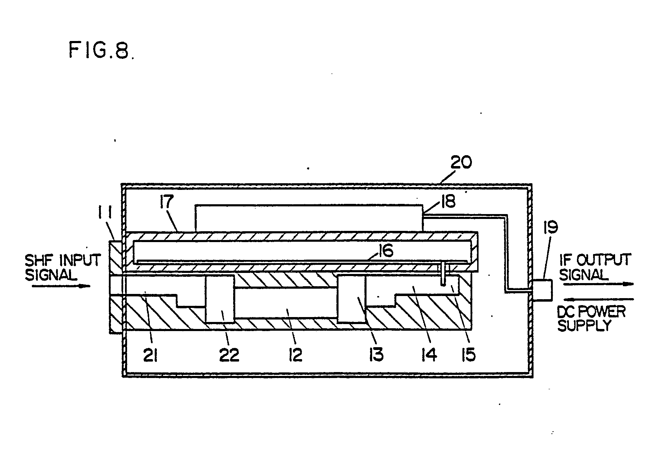

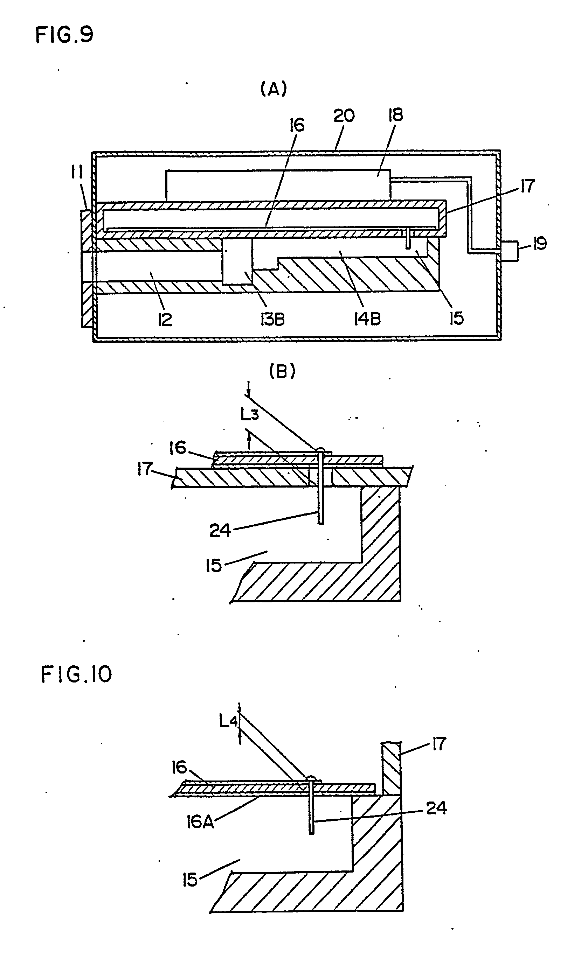

Figs. 1 and 2 are sectional views representing the constitution of conventional frequency converters for satellite broadcasting reception; Fig. 3 is a sectional view representing the constitution of frequency converter for satellite broadcast reception according to one of the embodiments of the present invention; Fig. 4 is a frequency distribution diagram showing the relation of frequencies of the frequency converter for satellite broadcast reception; Fig. 5A to E, Fig. 6a, b, and Fig. 7A to E are sectional views of examples of mutually different shapes of waveguide unit of respective converters; Fig. 8 is a sectional view of frequency converter for satellite broadcast reception in another embodiment; Fig. 9A, B are sectional views of the frequency converter of further embodiments; and Fig. 10 is a sectional views of an important part of the frequency converter of another embodiment.

Preferred embodiments for the execution of the invention

Referring now to the drawings, the frequency converter for satellite broadcast reception is described with respect to the embodiments of the present invention.

One of the embodiments relates to a frequency converter for satellite broadcast reception, and an example of constitution thereof is shown in Fig. 3. In this diagram, there are input flange unit 11, circular waveguide unit 12, circular-rectangular waveguide converter unit 13, and rectangular waveguide unit 14 which possesses a rectangular waveguide-microstrip line converter unit 15 in its final end. Besides, numeral 16 is a microwave integrated circuit, 17 is a shield case to accommodate said circuit 16, 18 represents other circuits, 19 is an output terminal, and 20 is an outer case.

In this constitution, an SHF signal form a broadcast satellite is fed to the circular waveguide unit 12 through the input flange 11, and propagates through the circular waveguide unit 12, and is converted from the circular transmission mode to a rectangular transmission mode in the circular-rectangular waveguide converter unit 13 to be transmitted to the rectangular waveguide unit 14. The signal then propagates through the rectangular waveguide unit and enters the microwave integrated circuit 16 by way of rectangular waveguide-microstrip line converter unit 15 provided in the final end of the rectangular waveguide unit 14. After necessary signal processing in the microwave integrated circuit 16, it is delivered from the output terminal 19 as a signal of intermediate frequency.

An example of frequency relation of the signals of frequency converter of such constitution is shown in Fig. 4. Supposing SHF signals from a satellite within a range of $F_{S1}=11.7$ GHz to $f_{S2}=12.2$ GHz, the local oscillation frequency $f_L$ is set to 10.76 GHz, and the signal of intermediate frequency as output is determined from $f_{IF1}=0.95$ GHz to $f_{IF2}=1.45$ GHz. In this case, the image frequency is within a range of $f_{M1}=9.3$ GHz to $f_{M2}=9.8$ GHz.

The transmission mode of SHF signal of circular waveguide unit 12 in Fig. 3 is propagation in $TE_{11}$ mode which is the principal mode of circular waveguide. Generally, when the electromagnetic field propagating in a circular waveguide is in $TE_{11}$ mode, the cutoff wavelength $\lambda_c$ and cutoff frequency $f_c$ are expressed as follows.

$$\lambda_c = \frac{2\pi a}{\hat{x}(m \cdot n)} \qquad (1)$$

where

a: radius of circular waveguide

$\hat{x}(m \cdot n)$: the root of Bessel $j'm(\hat{x}[m \cdot n])=0$; in the case of $TE_{11}$ mode, it is $j'l(\hat{x}(l \cdot l))=0$, and $\hat{x}(m \cdot n)=1.841$.

$$f_c = \frac{c}{\lambda_c} \qquad (2)$$

where

c: velocity of light.

According to eqs. (1) and (2), in Fig. 3, the radius a of circular waveguide unit 12 is set to be about 8 mm so that the cutoff frequency $f_c$ of circular waveguide unit 12 may be lower than the signal $f_{s1}=11.7$ GHz from satellite and higher than the local oscillation frequency $f_L=10.75$ GHz, being near 11.1 GHz. In this case, the

3

attentuation a applied by the circular waveguide unit 12 to the signal of frequency lower than the cutoff frequency of circular waveguide unit 12 is

$$a = \frac{2\pi}{\lambda} \sqrt{\left(\frac{\lambda}{\lambda_c}\right)^2 - 1} \quad [Nep/M] \tag{3}$$

where $\lambda$ is a free space wavelength.

Suppose the length of circular waveguide unit 12 in the axial direction to be 50 mm, then the attenuation is about 27 dB at local oscillation frqeuency $f_L$ and about 50 dB at image frequency $f_M$. On the other hand, since the signals from satellite $f_{S1}$ to $f_{S2}$ are hardly attenuated, the circular waveguide unit 12 presents the characteristic of a high pass filter, and the characteristics of image suppression ratio and local oscillation frequency signal leakage required in the frequency converter are extremely improved.

Meanwhile, the internal wavelength $\lambda_g$ of circular waveguide and characteristic impedance $Z_{wc}$ are expressed as follows.

$$\lambda g = \frac{\lambda}{\sqrt{1 - \left(\frac{\lambda}{\lambda_c}\right)^2}} \tag{4}$$

$$Z_{wc} = Z_o \frac{\lambda_g}{\lambda} \tag{5}$$

where: characteristic impedance in free space.

At frequency $f_{S1}$=11.7 GHz of SHF signal from the satellite, the wavelength and impedance are respectively $\lambda_{g1}$=approx. 85 [mm] and $Z_{wc1}$=approx. 1249 [ohms], and at $f_{S2}$=approx. 12.2 GHz, they are respectively $\lambda_{g2}$=approx. 61 [mm] and $Z_{wc2}$=approx. 930 [ohms]. Thus it is evident that there is a considerable difference in the internal wavelength and characteristic impedance of waveguide between the frequencies at both ends of 500 MHz frequency band of signal. Therefore, it is impossible to effect waveguide-microstrip line conversion in excellent characteristics over the entire region of 500 MHz of signal bandwidth in this circular waveguide unit 12 alone.

Accordingly, in the present invention, the circular-rectangular waveguide converter unit 13 is provided to convert the transmission mode of signal from circular mode $TE_{11}$ to $TE_{10}$ which is the principal mode of rectangular waveguide. The section of the rectangular waveguide unit 14 after rectangular conversion is shown in section D—D' in Fig. 5E. The internal wavelength $\lambda_g$ and characteristic impedance $Z_{WR}$ of the rectangular waveguide unit 14 having this section are expressed as follows.

$$\lambda g = \frac{\lambda}{\sqrt{1 - \left(\frac{\lambda}{2a}\right)^2}} \tag{6}$$

$$Z_{WR} = Z_o \cdot \frac{2b}{a} \cdot \frac{\lambda_g}{\lambda} \tag{7}$$

That is, at frequency $f_{S1}$=11.7 GHz of SHF signal, the wavelength is $\lambda_g$=approx. 35 [mm] and impedance is $Z_{wc}$=509 [ohms], and at $f_{S2}$=12.2 GHz, they are respectively $\lambda_g$=32 [mm] and $Z_{wc}$=493 [ohms], and there is no significant difference in the frequency between the both ends of 500 MHz band.

In the final end part of the rectangular waveguide unit 14 in Fig. 3, the rectangular waveguide-microstrip line converter unit 15 is provided, and the rectangular waveguide-microstrip line conversion is effected easily, and the signals from the satellite are introduced into the microwave integrated circuit 16.

On the other hand, regarding the circular-rectangular waveguide conversion, as mentioned above, since the difference in the characteristic impedance between the circular waveguide unit 12 and rectangular waveguide unit 14 is relatively large, it is expected to be difficult to convert efficiently over the entire signal band of 500 MHz by a single step conversion alone. Therefore, in such a case, an efficient conversion may be achieved by using two-step converter.

A particularly notable feature of the present invention, as shown in this embodiment of the circular-rectangular waveguide converter unit 13 is that not only the circular-rectangular converting function is provided, but also the axis of circular waveguide unit 12 and that of rectangular waveguide unit 14 are deviated in a direction parallel to a shorter side of the rectangular waveguide unit 14 by properly selecting the dimensions of the circular-rectangular converter unit.

4

Details of the circular-rectangular waveguide unit 13 are shown in Fig. 5A to E. As understood from the drawing, the $TE_{11}$ mode of circular waveguide unit 12 is first converted to the mode of rectangular waveguide unit possessing the characteristic impedance of high impedance by the step converter 13 of the first step, and is then converted to the rectangular transmission mode $TE_{10}$ of low impedance gradually through the second step converter 13'.

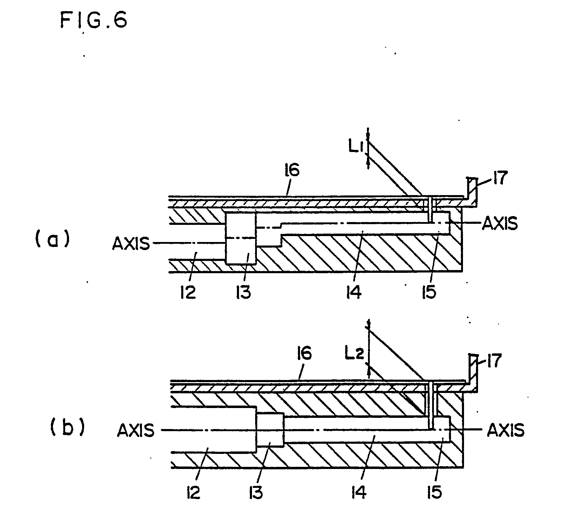

Fig. 6b shows, by way of explanation a waveguide unit of circular-rectangular waveguide conversion, in which, the axis of the circular waveguide unit 12 and that of the rectangular waveguide unit 14 coincide with each other. Fig. 6a shows, for comparison, waveguide units of a frequency converter according to the present invention.

Although it is possible to use in the same shape and state as shown in Fig. 6b, the dimension L2 is enlarged when applied to a frequency converter, and the attenuation of signal becomes larger as compared with the dimension of L1 in the rectangular waveguide-microstrip line converter unit 15, shown in Fig. 6a. This attenuation may give rise to deterioration of noise index characteristic required in the converter. Hence, in order to provide an advanced characteristic, as shown in Fig. 6a, the circular-rectangular waveguide converter unit 13 is provided with both circular-rectangular waveguide converting function and the function to move the axis of the waveguide parallel in the direction of shorter side of the rectangular waveguide, and the dimension of L1 in Fig. 6a is minimized to prevent deterioration of noise index.

Though the example above relates to two-step operation of circular-rectangular waveguide conversion, it is generally most natural to use taper waveguide in the circular-rectangular mode conversion, and the reflection is decreased as a matter of course when gradually converted from circular to rectangular mode.

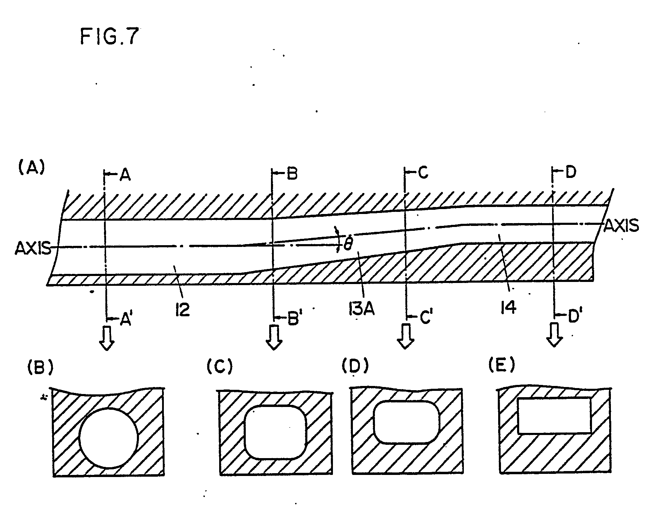

An embodiment using taper waveguide is shown in Fig. 7A to E. As shown in Fig. 7A, the mode is converted from circular to rectangular by a taper waveguide 13A having a certain inclination θ against the axis of the circular waveguide unit 12, and the axis of circular waveguide unit 12 and that of rectangular waveguide unit 14 are simultaneously moved parallel.

In addition to the frequency converter in which the signals received from the satellite are fed in $TE_{11}$ mode of circular waveguide explained so far, an embodiment is possible in which signals are fed in $TE_{10}$ mode of rectangular waveguide as shown in Fig. 8.

In Fig. 8, in the concept of feeding inputs in $TE_{10}$ mode of the rectangular waveguide, a converter unit (which is a rectangular-circular waveguide converter unit 22) identical in shape with the circular-rectangular waveguide unit in Fig. 3 is placed before the circular waveguide unit 12 shown in Fig. 3, and a rectangular waveguide unit 21 is provided before this rectangular-circular waveguide converter unit 22. In this constitution, the reception signal fed from the input flange unit 11 propagates through the rectangular waveguide unit 21 in $TE_{10}$ mode, and is converted to $TE_{11}$ mode of the circular waveguide unit 12 in the rectangular-circular waveguide converter unit 22, and is applied into the circular waveguide unit 12 which acts as a high pass filter. The subsequent operation is same as in the explanation of Fig. 3.

Other embodiment is shown in Fig. 9A, B. This embodiment is intended to satisfy the image suppression ratio, leakage prevention of local oscillation signal, and noise index characteristic, and also to reduce the size. For these purposes, the H-wall of circular-rectangular waveguide converter unit 13 and rectangular waveguide converter unit 14 in Fig. 3 is composed of shield case 17 of microwave integrated circuit 16. The constitution of the other parts is the same as in Fig. 3. In this constitution, as shown in the detailed view in Fig. 9B, the dimension L3 in the rectangular-microstrip line converter unit 15 may be further reduced, and the signal attenuation in this part may be held to a minimum, and the size of the equipment may be reduced without deteriorating the noise index characteristic.

Another embodiment is shown in Fig. 10. In this construction, the H-wall of circular-rectangular waveguide converter unit 13 and rectangular waveguide unit 14 in Fig. 3 is composed of grounding plate 16A of dielectric substrate as used in the microwave integrated circuit 16. In this constitution, the dimension L4 may be further decreased, so that the size may be much smaller. Meanwhile, in Figs. 9 and 10, the operation is similar to that of previous embodiments, and numeral 24 in Figs. 9 and 10 refers to a probe set up on the microwave integrated circuit 16.

The technique in Figs. 9 and 10 may be applied to the embodiment in Fig. 7.

Possibilities of industrial uses

According to the present invention, as disclosed above, by installing a circular waveguide unit having high pass filter characteristics and disposing the circular waveguide unit and rectangular waveguide unit at an axially deviated configuration, a high performance frequency converter satisfying all the requirements of image suppression ratio, leakage prevention of local oscillation signal, and noise index characteristic may be obtained, and it is particularly suitable for use in satellite broadcast reception.

**Claims**

1. A frequency converter comprising:
a circular waveguide unit (12) having an end to which a reception signal is applied, a rectangular waveguide unit (14) and a circular-rectangular waveguide converter unit (13) which connects the other end of the circular waveguide unit (12) to the rectangular waveguide unit (14) to convert a transmission mode of

**0 131 633**

the reception signal from $TE_{11}$ mode in the circular waveguide into a $TE_{10}$ mode in the rectangular waveguide (14) which is a main mode thereof; wherein the diameter of the circular waveguide unit is selected so that the cutoff frequency (fc) of the circular waveguide unit is lower than the frequency of the signal to be processed and higher than the local oscillation frequency so as to cause the circular waveguide unit to function as a high pass filter, characterised in that a rectangular waveguide-microstrip line converter unit (15) is provided at the final end of the rectangular waveguide and a microwave integrated circuit (16) is provided to process the reception signal fed there to through the rectangular waveguide-microstrip line converter unit to produce the processed signal as a signal of intermediate frequency, and the axis of said rectangular waveguide is arranged to be displaced with respect to the circular waveguide unit parallel to the direction of a shorter side of the rectangular waveguide unit and said microwave integrated circuit is provided at the side of the walls of said circular-rectangular waveguide converter unit and said rectangular waveguide unit towards which the axis of the rectangular waveguide unit is displaced.

2. A frequency converter as claimed in claim 1, wherein said circular-rectangular waveguide converter unit is constituted by a first step converter have a characteristic impedance and arranged to convert a $TE_{11}$ mode of circular waveguide unit into a transmission mode $TE_{10}$ of rectangular waveguide unit, and a second step converter arranged to convert this transmission mode $TE_{10}$ into another transmission mode $TM_{10}$ of lower impedance.

3. A frequency converter as claimed in claim 1, wherein said circular-rectangular waveguide converter unit is constituted by a taper waveguide having a proper angle with respect to the axis of said circular waveguide unit.


**Patentansprüche**

1. Frequenzumwandler, enthaltend:

eine Wellenleitereinheit (12) mit kreisförmigem Querschnitt, die ein Ende aufweist, an das ein Empfangssignal angelegt wird, eine Wellenleitereinheit (14) mit rechteckigem Querschnitt und eine Kreisform/Rechteckform-Wellenleiterwandlereinheit (13), die das andere Ende der Wellenleitereinheit (12) kreisförmigen Querschnitts mit der Wellenleitereinheit (14) rechteckigen Querschnitts verbindet, um einen Übertragungsmode des Empfangssignals vom $TE_{11}$-Mode im Wellenleiter kreisförmigen Querschnitts in einen $TE_{10}$-Mode im Wellenleiter (14) rechteckigen Querschnitts umzuwandeln, der ein Hauptmode desselben ist, wobei der Durchmesser der Wellenleitereinheit kreisförmigen Querschnitts so gewählt ist, daß die Abschneidfrequenz (fc) der Wellenleitereinheit kreisförmigen Querschnitts niedriger ist, als die Frequenz des zu verarbeitenden Signals, und höher ist, als die Überlagererfrequenz, um zu bewirken, daß die Wellenleitereinheit kreisförmigen Querschnitts als Hochpaßfilter wirkt,

dadurch gekennzeichnet, daß eine Rechteckformwellenleiter/Mikrostripleitungs-Wandlereinheit (15) am hinteren Ende des Wellenleiters rechteckigen Querschnitts vorgesehen ist und eine integrierte Mikrowellenschaltung (16) vorgesehen ist, um das über die Rechteckformwellenleiter/Mikrostripleitungs-Wandlereinheit zugeführte Empfangssignal zu verarbeiten, um das verarbeitete Signal als ein Signal der Zwischenfrequenz zu erzeugen, und daß die Achse des Wellenleiters rechteckigen Querschnitts so angeordnet ist, daß sie gegenüber der Achse der Wellenleitereinheit kreisförmigen Querschnitts parallel zur Richtung einer kürzeren Seite der Wellenleitereinheit rechteckigen Querschnitts versetzt ist, und daß die integrierte Mikrowellenschaltung an der Seite der Wände der Kreisform/Rechteckform-Wellenleiterwandlereinheit und der Wellenleitereinheit rechteckigen Querschnitts angeordnet ist, gegen die die Achse der Wellenleitereinheit rechteckigen Querschnitts versetzt ist.

2. Frequenzumwandler nach Anspruch 1, bei dem die Kreisform/Rechteckform-Wellenleiterwandlereinheit gebildet ist von einem Wandler erster Stufe, der eine charakteristische Impedanz hat und dazu eingerichtet ist, einen $TE_{11}$-Mode der Wellenleitereinheit kreisförmigen Querschnitts in einen Übertragungsmode $TE_{10}$ der Wellenleitereinheit rechteckigen Querschnitts umzuwandeln, und von einem Wandler zweiter Stufe, der dazu eingerichtet ist, diesen Übertragungsmode $TE_{10}$ in einen weiteren Übertragungsmode $TE_{10}$ einer niedrigeren Impedanz umzuwandeln.

3. Frequenzumwandler nach Anspruch 1, bei dem die Kreisform/Rechteckform-Wellenleiterwandlereinheit gebildet ist von einer konischen Wellenleitung, die einen geeigneten Winkel in bezug auf die Achse der Wellenleitereinheit kreisförmigen Querschnitts hat.


**Revendications**

1. Convertisseur de fréquence comportant:

une unité de guide d'onde circulaire (12) ayant une extrémité à laquelle est appliqué un signal de réception, une unité de guide d'onde rectangulaire (14) et une unité de convertisseur de guide d'onde circulaire-rectangulaire (13) qui connecte l'autre extrémité de l'unité de guide d'onde circulaire (12) à l'unité de guide d'onde rectangulaire (14) pour convertir un mode de transmission du signal de réception du mode $TE_{11}$ dans le guide d'onde circulaire en un mode $TE_{10}$ dans le guide d'onde rectangulaire (14) qui est son mode principal; dans lequel le diamètre de l'unité de guide d'onde circulaire est choisi de manière que la fréquence de coupure (fc) de l'unité de guide d'onde circulaire soit inférieure à la fréquence du signal à

0 131 633

traiter et supérieure à la fréquence d'oscillation locale de manière que l'unité de guide d'onde circulaire fonctionne comme un filtre passe-haut,

caractérisé en ce qu'une unité de convertisseur (15) de guide d'onde rectangulaire en ligne à ruban est prévue à l'extrémité finale du guide d'onde rectangulaire et un circuit intégré à hyperfréquence (16) est prévu pour traiter le signal de réception qui lui est transmis par l'unité de convertisseur de guide d'onde rectangulaire en ligne à ruban pour produire le signal traité comme un signal de fréquence intermédiaire, et l'axe du guide d'onde rectangulaire étant disposé de manière à être décalé par rapport à l'unité de guide d'onde circulaire parallèlement à la direction du côté le plus court de l'unité de guide d'onde rectangulaire et ledit circuit intégré à hyperfréquence étant disposé sur le côté des parois de l'unité de convertisseur de guide d'onde circulaire-rectangulaire et de ladite unité de guide d'onde rectangulaire vers lequel l'axe de l'unité de guide d'onde rectangulaire est décalé.

2. Convertisseur de fréquence selon la revendication 1, dans lequel ladite unité de convertisseur de guide d'onde circulaire-rectangulaire est constituée par un convertisseur de premier étage ayant une impédance caractéristique et agencé pour convertir un mode $TE_{11}$ de l'unité de guide d'onde circulaire en un mode de transmission $TE_{10}$ de l'unité de guide d'onde rectangulaire et un convertisseur de second étage pour convertir ce mode de transmission $TE_{10}$ en un autre mode de transmission $TM_{10}$ de plus faible impédance.

3. Convertisseur de fréquence selon la revendication 1, dans lequel ladite unité de convertisseur de guide d'onde circulaire-rectangulaire est constituée par un guide d'onde conique ayant un angle approprié par rapport à l'axe de ladite unité de guide d'onde circulaire.

7

FIG.1

SHF INPUT
SIGNAL

IF OUTPUT
SIGNAL

DC POWER
SUPPLY

8

5

4

1

7

2 3 6

1

FIG.2

SHF INPUT
SIGNAL

IF OUTPUT
SIGNAL

DC POWER
SUPPLY

FIG.3

SHF INPUT
SIGNAL →

IF OUTPUT
SIGNAL →
← DC POWER
SUPPLY

11 17 18 16 20 19
12 13 14 15

FIG.4

fIF1    fIF2        fM1    fM2      fL   fC   fS1        fS2

0Hz 0.95GHz  1.45GHz    9.3GHz    9.8GHz   10.75GHz 11.7GHz    12.2GHz

FREQUENCY ———►
(Hz)

FIG.5

(A)

(B)  a≒8mm

(C)

(D)

(E)  a≒19.05mm
b≒9.53mm

1

FIG.6

(a)

(b)

FIG.7

(A)

AXIS

AXIS

12    13A    14

$\theta$

A—A'    B—B'    C—C'    D—D'

(B)    (C)    (D)    (E)

FIG.8.

SHF INPUT
SIGNAL

IF OUTPUT
SIGNAL

DC POWER
SUPPLY

11   17   20   18   19   16

21   22   12   13   14   15

FIG.9

(A)

(B)

FIG.10